# EUROPÄISCHE PATENTSCHRIFT

(11) **EP 0 516 986 B1**
(45) Veröffentlichungstag und Bekanntmachung des Hinweises auf die Patenterteilung: **19.10.1994**
(21) Anmeldenummer: 92107604.8
(22) Anmeldetag: 06.05.1992
(51) Int. Cl.: H05K 9/00, H05K 7/14

(54) **Baugruppenträger**
Electronic rack
Rack électronique

(30) Priorität: 03.05.1991 DE 4114484; 12.08.1991 DE 4126576; 20.12.1991 DE 9115845 U
(43) Veröffentlichungstag der Anmeldung: 09.12.1992
(73) Patentinhaber: Licentia Patent-Verwaltungs-GmbH, 60596 Frankfurt (DE)
(72) Erfinder: Haxel, Gerd, W-6453 Seligenstadt (DE); Bohnenberger, Willy, W-6451 Mainhausen 2 (DE); Hörbe, Siegfried, W-6393 Wehrheim 1 (DE)
(74) Vertreter: Erbacher, Alfons, Dipl.-Ing.

(56) Entgegenhaltungen:
- EP-A- 0 200 054
- EP-A- 0 207 226
- AT-B- 374 655
- DE-A- 3 640 817
- DE-A- 3 928 461
- DE-A- 4 016 797

## Beschreibung

Die Erfindung bezieht sich auf einen Baugruppenträger mit zwei metallischen Seitenwänden, zwischen denen an den vier Ecken jeweils Profilschienen aus Metall verlaufen, die an den Seitenwänden befestigt sind und Führungshalter tragen, in denen Baugruppen angeordnet sind, wobei eine obere und/oder eine untere metallische Abdeckplatte jeweils elektrisch leitend mit den vorderen und rückwärtigen Profilschienen und den Seitenwänden verbunden sind und wobei insbesondere die metallischen oder metallisierten Frontplatten der Baugruppen U-förmig ausgebildet sind und einen ersten Schenkel mit einer Blattfeder und einen zweiten Schenkel aufweisen, der als Kontaktfläche für die leitende Verbindung mit der Blattfeder des ersten Schenkels der im Baugruppenträger benachbarten Frontplatte ausgebildet ist.

Ein Baugruppenträger der vorstehend beschriebenen Art ist bereits bekannt (DE 39 28 461 A1). Mit diesem Baugruppenträger wird eine gute Abschirmung des Innenraums gegen äussere elektromagnetische Felder und des Raums ausserhalb des Baugruppenträgers vor im Baugruppeninnern erzeugten elektromagnetischen Feldern erreicht.

Die Blattfedern sind bei dem bekannten Baugruppenträger bogenförmig ausgebildet und liegen an den beiden Enden des Bogens an dem Schenkel an. Beim Einschieben einer Baugruppe wird die Wölbungshöhe der Blattfeder von dem Schenkel der benachbarten Baugruppe verkleinert, wodurch sich die Wölbungsbreite vergrössert.

Dabei gleitet ein freies Ende der Feder auf einer ebenen Schenkelfläche während das andere Ende in einer Nut des Schenkels festgehalten wird.

Neben dem zusammendrücken der Wölbung erfordert insbesondere die Verschiebung des freien Federendes auf der Gleitfläche einen grossen Kraftaufwand. Da die zu überwindende Reibungskraft mit der Anpresskraft zunimmt, wirkt sich die Reibungskraft in einer erhöhten Steifigkeit der Feder aus. Beim Einschieben und Herausziehen von Baugruppen sind daher zusätzlich zu den von den Steckverbindern verursachten Reibungskräften noch weitere grosse Reibungskräfte zu überwinden, die von einer Seite auf die Baugruppe einwirken, diese also nicht gleichmässig beanspruchen. Diese ungleichmässigen Beanspruchungen können sich ungünstig auf das Einschieben und Herausziehen der Baugruppen insbesondere dann auswirken, wenn diese und die Führungshalter dünnwandige Tragteile enthalten. Vielfach werden die Frontplatten mit Klammerverbindungsteilen am Baugruppenträger befestigt. Diese Klammerverbindungsteile sind durch die oben beschriebenen Blattfedern seitlichen Kräften ausgesetzt, denen sie nachgeben können, wodurch sich die Baugruppen in Richtung unbelegter Baugruppenplätze verschieben können.

Es ist ein U-förmig gebogenes, federndes Kontaktelement bekannt, das zwischen zwei aneinandergrenzenden Aussenwandteilen eines aus Blech bestehenden Gehäuses angeordnet ist. Das Kontaktelement liegt am Rand und an den dem Rand benachbarten Bereichen der einen Wand mit den ebenen Abschnitten der beiden Schenkel an. Der an der Aussenseite der Wand liegende Schenkel enthält im Anschluss an den ebenen Abschnitt eine nach aussen weisende Wölbung, deren Ende durch eine Ausnehmung in der Wand geführt ist und mit dem abgewinkelten Rand an der Innenseite der Wand anliegt. Der auf der Innenseite der Wand angeorndete Schenkel weist eine Ausnehmung auf, in die ein auf der Wandinnenseite angeordneter Noppen eingreift (DE-GM 88 15 986).
Schliesslich ist ein hochfrequenzdichtes Gehäuse mit einem Gehäuseunterteil und einem Deckel bekannt, dessen den Rand des Gehäuseunterteils überlappender Rand einen Federblechstreifen trägt.

Der Federblechstreifen umgibt U-förmig den Rand und weist zwei Schenkel auf, von denen ein äusserer eben am Deckel aufliegt und ein innerer einen ebenen, am Gehäuse anliegenden Abschnitt enthält, von dem eine Wölbung ausgeht, die gegen das Gehäuseunterteil angedrückt ist. An der Basis der Wölbung ist ein Widerhaken vorgesehen, der den Federblechstreifen am Deckel festhält (ER 0 207 226 A1).

Baugruppenträger der vorstehend beschriebenen Art werden als Einschübe in Gestelle oder Schränke eingesetzt. Bekannt sind im 19-Zoll-Aufbausystem genormte Baugruppenträger mit einem Breitenmass von 19˝ und einem Höhenschritt von 44,45 mm. Die Baugruppenträger werden für die Aufnahme und Befestigung "elektronischer" bzw. elektrischer Bauteile verwendet. Sie können als Tragelemente Profilschienen oder Profilbleche aufweisen. Baugruppenträger sind z. B. in dem Buch "Handbuch des 19˝-Aufbausystems", Markt & Technik Verlag, 1986, Seiten 95 bis 118 beschrieben.

Der Erfindung liegt daher das Problem zugrunde, für in Baugruppenträger der oben beschriebenen Art einsetzbare Baugruppen eine verbesserte Blattfederanordnung zu entwickeln, die bei niedrigem elektrischen Übergangswiderstand zu benachbarten Gleitflächen eine geringere Kraft beim Herausziehen und Einschieben von Baugruppen erfordert und die beim Fehlen einer benachbarten Gleitfläche aufgrund ihrer Konstruktion nur eine geringe seitliche Kraftkomponente aufweist. Die Abschirmung des Baugruppenträgers soll verbessert werden.

Das Problem wird bei Frontplatten erfindungsgemäss durch die Merkmale im Patentanspruch 1 gelöst. Bei der im Anspruch 1 beschriebenen Anordnung hat die Feder eine weiche Federcharakteristik, obwohl sie um ein gewisses Mass gegen die Baugruppe ausgelenkt ist, wenn sie z. B. an der Gleitfläche einer benachbarten Frontplatte anliegt. Der Kraftaufwand beim Einschieben und Herausziehen von Baugruppen ist daher geringer. Die Gleitflächen werden auch weniger abgenutzt. Aufgrund der Form der Feder ist der Raumbedarf in Längsrichtung der Profilschienen gering. Es steht daher ausreichend Raum für andere Zwecke, z. B. einen Kontakt zur Erdung der Leiterplatte der Baugruppe oder einen Hebelmechanismus zur Verfügung, der als Steck- und Ziehhilfe für die Baugruppen verwendet wird.
Vorzugsweise ist auf der Innenseite jeder Seitenwand am vorderen Ende zwischen der oberen und unteren Profilschiene eine Leiste befestigt, wobei zwischen der Seitenwand und der Leiste die Blattfeder eingespannt ist, die in einem Bogen um die Schmalseite der Leiste verläuft und auf ihrer der Seitenwand entgegengesetzten Seite einen Absatz aufweist, der in eine die Bewegung in Richtung der benachbarten Baugruppe angrenzende Nut ragt.

Über die Blattfedern und die beiden Leisten werden leitende Verbindungen zwischen den Frontplatten und den Seitenwänden hergestellt. Die Blattfedern haben die gleiche Form und die gleichen Abmessungen wie die an den Schenkeln der Frontplatten angeordneten Blattfedern. Durch die Verwendung gleicher Blattfedern vermindert sich der Bauteileaufwand und der Aufwand für die Herstellungswerkzeuge.

Günstig ist es auch, wenn die rückwärtigen Profilschienen jeweils eine nach oben oder unten offene Nut mit einer Kontaktfeder aufweisen, die gegen den die Ecke der Profilschiene umgreifenden abgebogenen Rand der rückwärtigen Abdeckplatte angedrückt ist. Bei dieser Ausführungsform müssen die rückwärtigen Profilschienen nicht als Winkelschienen ausgebildet sein. Die vorderen, die üblicherweise die Verdrahtung tragenden mittleren und rückseitigen Profilschienen können deshalb gleiche Höhen haben. Dies bedeutet, dass an der Rückseite der Baugruppe mehr Raum für die Anschlüsse an Baugruppen verfügbar ist. Die rückseitigen Profilschienen sind ebenso wie die vorderen Profilschienen mit von den Stirnseiten nach innen verlaufenden Nuten ausgestattet, die einen kreuzförmigen Querschnitt haben. In die Nuten sind Gewindeleisten oder Gleitmuttern eingesetzt, an denen die rückwärtige Abdeckhaube angeschraubt wird. Es können somit die gleichen Befestigungsmittel, wie sie für die Befestigung der Frontplatten verwendet werden, auch zur Befestigung der rückseitigen Abdeckhaube verwendet werden. Der Baugruppenträger lässt sich daher besonders wirtschaftlich fertigen. Die obere und die untere Abdeckplatte haben jeweils abgewinkelte seitliche Ränder, die an den Seitenwänden angeschraubt sind.

Zwischen der Kante und den Gewindebohrungen sind Kontaktnoppen geformt, die beim Anschrauben fest gegen die jeweilige Seitenwand gepresst werden und eine elektrisch gut leitende Verbindung zwischen beiden Teilen herstellen. Für die mittleren Profilschienen sind die seitlichen Ränder der Abdeckplatte ausgespart.

Mit einer Weiterbildung der oben beschriebenen Erfindung soll bei Baugruppenträgern erreicht werden, dass auch bei Anordnung einer abnehmbaren oder aufklappbaren, metallischen Frontplatte eine gute Abschirmwirkung erzielt wird.

Die Aufgabe wird bei einem Baugruppenträger erfindungsgemäss dadurch gelöst, dass die Frontplatte abgewinkelte seitliche Ränder hat, dass zwischen den Seitenwänden und den diese innen ein Stück überlappenden Rändern Blattfedern angeordnet sind, die zwischen eingespannten Enden und quer zu der Seitenwand bzw. dem Rand innerhalb von Anschlägen auslenkbaren Enden Bögen aufweisen, mit denen die Blattfedern V- oder U-förmig umgelenkt werden. Bei dieser Vorrichtung haben die Federn aufgrund der Bögen weiche Federcharakteristiken, obwohl sie um ein gewisses Mass lateral zu den Seitenwänden ohne Frontplatte ausgelenkt und mit Frontplatte zusammengedrückt sind. Der Kraftaufwand beim Einfügen oder Herausnehmen der Frontplatte ist aufgrund der weichen Federcharakteristik gering. Die Anpresskräfte der Federn bleiben über sehr lange Zeiträume erhalten. Mit den Federn wird an den Spalten zwischen der Frontplatte und den Seitenwänden eine sehr gute Abschirmung des Baugruppenträgers erreicht.

Bei einer bevorzugten Ausführungsform ist jeweils eine Blattfeder auf jeder Innenseite einer Seitenwand des Baugruppenträgers eingespannt. Diese Anordnung ermöglicht die Verwendung von die ganze Öffnung verschliessenden Frontplatten, wobei jeweils an den Spalten der Seitenwände eine Feder an einer in Richtung des Baugruppenträgerinneren ragenden Metallfläche anliegt. Wenn sich die Frontplatte über die volle Breite des Baugruppenträgers erstrecken, reichen abgewinkelte Ränder aus, die gegen die an den Seitenwänden befestigten Blattfedern angedrückt werden.

Es ist zweckmässig, die Blattfedern jeweils an einem Ende zwischen einer Leiste und einer Auflagefläche einzuspannen, wobei die Blattfedern in Bögen V- oder U-förmig um die Schmalseiten der Leisten geführt sind und mit ihren anderen Enden in Nuten der Leisten ragen, deren Weite die Auslenkung der Blattfedern zwischen zwei Endlagen bestimmt. Die Leisten können nahe an den vorderen Enden der Seitenwände angeschraubt werden.

Da die Seitenwände der Baugruppenträger rechtwinklig gegen die Öffnung abgewinkelte Enden haben, befinden sich die Leisten hinter den abgewinkelten Enden und nur die Federn ragen über die Enden hinaus.

Bei einer weiteren bevorzugten Ausführungsform enthält die Frontplatte eine vordere erste ebene Platte, auf deren Rückseite eine zweite innere Platte mit abgewinkelten Rändern angeordnet ist, von denen ein Rand mit dem einen Rand der vorderen Platte fluchtet und der zweite Rand gegen den anderen Rand der vorderen Platte in Richtung der Frontplattenmitte um die Breite einer Leiste zurückgesetzt ist, die am abgewinkeltem Rand unter Einspannung einer Blattfeder befestigt ist, die einen Bogen um den der Vorderseite der Frontplatte abgewandten Rand der Leiste macht und mit einem gegen die Plattenmitte abgewinkelten Ende an die innere Platte angrenzt. Die vorstehend beschriebene Frontplatte eignet sich für Steckbaugruppen, die mehrere Teilungen im Rastermass des Baugruppenträgers einnehmen. Diese Steckbaugruppen können mit Baugruppen, die weniger Teilungen, z. B. vier, benötigen, gemeinsam in einem Baugruppenträger angeordnet sein. Besonders zweckmässig ist es, wenn eine der beiden Platten aus Stahl besteht, wodurch elektromagnetische Felder stark gedämpft werden. Die vordere Platte besteht z. B. aus Aluminium und die hintere Platte aus Stahl, das verzinkt ist.

Vorzugsweise ist an der rückwärtigen Seite des Baugruppenträgers eine im Quer- und Längsschnitt U-förmige Haube befestigt, an deren abgebogenen Seitenwänden jeweils Leisten befestigt sind, die mit den Seitenrändern Blattfedern verbinden, die an den Seitenwänden des Baugruppenträgers anliegen und in Bögen um die dem Baugruppenträger zugewandten Enden der Leisten verlaufen und in Richtung der Haubenmitte abgewinkelte Enden haben, die in Nuten der Leisten ragen, deren Seitenwände die Auslenkung quer zu den Seitenrändern begrenzen. Die Federn stellen bei dieser Vorrichtung niederohmige Verbindungen zwischen der Haube und den Seitenwänden des Baugruppenträgers her, so dass eine gute Abschirmwirkung erzielt wird. Ausserdem haben die Federn wegen ihrer durch die Bögen hervorgerufenen Längen eine weiche Federcharakteristik, so dass die Haube ohne grossen Kraftaufwand in ihre Montagestellung gebracht oder aus dieser gelöst werden kann.

Einer Weiterbildung des obengenannnten Baugruppenträgers liegt das Problem zugrunde, einen Baugruppenträger der eingangs beschriebenen Gattung dahingehend weiterzuentwickeln, dass auch an denjenigen Stellen der Frontplatten, die den Profilschienen zugewandt sind, eine gute Abschirmwirkung durch niederohmige Kontaktflächen in ausreichender Zahl erreicht wird.

Das Problem wird erfindungsgemäss durch die Merkmale im Patentanspruch 11 gelöst. Bei der im Patentanspruch 11 beschriebenen Vorrichtung werden mittels der Feder in gleichmässigen Abständen elektrische Kontaktflächen zwischen Profilschienen und Frontplatten erzeugt. Diese Kontaktflächen bewirken unabhängig von den weitereen Auflageflächen zwischen Frontleisten und Profilschienen eine gute Abschirmung von inneren und äusseren Störfeldern auch bei breiteren Frontplatten.

Aufgrund des grösseren Abstands zwischen den Auflagestellen in dem verbreiterten Nutabschnitt und der Nutwand ergibt sich ein grösserer Auslenkweg, so dass die Blattfeder eine weiche Charakteristik hat. Dies bedeutet, dass die Frontplatten ohne grossen Widerstand der Blattfedern gegen die Profilleisten gedrückt werden können. Die Aussparungen, deren Abstände an die Abstände zwischen den Befestigungsbohrungen der Frontplatten angepasst sind, erlauben die Befestigung der Frontplatten an Gewindeleisten oder Gleitmuttern, die in die Nut eingesetzt sind.

Vorzugsweise erstrecken sich die Aussparungen im Abstand von Gewindebohrungen von einer Gewindeleiste schlitzförmig über die abgewinkelten Enden der Blattfedern. Auf diese Weise ergeben sich einzelne Federelemente, die für sich federnd von einer gemeinsamen Basis ausgehen. Damit kann eine bessere Anpassung an die jeweiligen Gegebenheiten der Frontplatte erreicht werden. Die Blattfeder enthält vorzugsweise an einem Ende einen ebenen Bereich, der in einen der Erweiterung auf einer Seite der Nut angepassten Bogen übergeht, der sich in einem geraden Abschnitt fortsetzt, der nach einer der Breite der Nut entsprechenden Strecke gewölbt in einen weiteren geraden Abschnitt übergeht, an den sich das abgewinkelte Ende anschliesst. Bei dieser Ausführungsform lassen sich die Enden beim Einlegen der Blattfeder in die Nut leicht zusammenbiegen, so dass die Montage erleichtert wird.

Die Erfindung wird im folgenden anhand eines in einer Zeichnung dargestellten Ausführungsbeispiels näher beschrieben, aus dem sich weitere Einzelheiten, Merkmale und Vorteile ergeben.

Es zeigen
- Fig. 1: ein Baugruppenträger im Querschnitt;
- Fig. 2: einen Schnitt längs der Linien I-I des in Fig. 1 dargestellten Baugruppenträgers;
- Fig. 3: eine Kontaktfeder in Seitenansicht;
- Fig. 4: einen Schnitt der hinteren Ecke des in Fig. 1 dargestellten Baugruppenträgers;
- Fig. 5: eine obere Abdeckplatte im Längsschnitt;
- Fig. 6: einen Ausschnitt der in Fig. 2 dargestellten Anordnung;
- Fig. 7: einen Ausschnitt des in Fig. 1 dargestellten Baugruppenträgers im Detail von oben;
- Fig. 8: eine Baugruppe mit einer Frontplatte im Querschnitt;
- Fig. 9: eine der vorderen Profilschienen des Baugruppenträgers im Querschnitt;

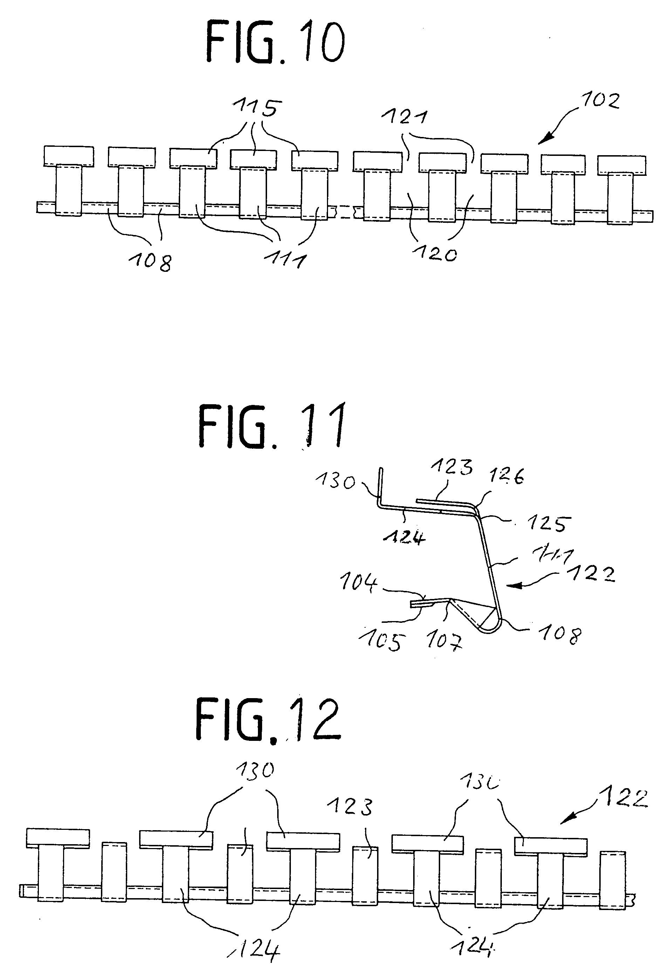

- Fig. 10: eine in eine Nut der Profilschiene einsetzbare Blattfeder in einer Ansicht von hinten;
- Fig. 11: eine andere Ausführungsform einer in eine Nut der Profilschiene einsetzbaren Blattfeder im Querschnitt;
- Fig. 12: die Blattfeder gem. Fig. 4 in einer Ansicht von hinten und
- Fig. 13: eine Frontplatte einer Steckbaugruppe von oben.

Ein Baugruppenträger 1 enthält zwei Seitenwände 2, 3 und mindestens vier Profilschienen 3a, 4, 5 und 6, die sich zwischen den Seitenwänden 2, 3 erstrecken und jeweils an den vier Ecken der Seitenwände 2, 3 an diesen befestigt sind. Die Profilschienen 3a bis 6 und mittlere Profilschienen 63, 64 weisen jeweils in Längsrichtung verlaufende Gewinde 7 auf, in die von den Seitenwänden 2, 3 aus durch Bohrungen Schrauben eingesetzt sind, um die Seitenwände 2 mit den Profilschienen 3a bis 6, 63 und 64 zu verschrauben. Die Seitenwände 2, 3 und die Profilschienen 3a bis 6, 63 und 64 bestehen aus Metall, insbesondere aus Aluminium.

Zwischen den Profilschienen 3, 5, 63 und 64 erstrecken sich Führungshalter 8, 9, die durch Rastverbindungen an den Profilschienen befestigt sind. Die Führungshalter 8, 9 stehen sich paarweise auf verschiedenen Seiten des Baugruppenträgers 1 gegenüber und sind mit nicht näher bezeichneten Nuten versehen, deren offene Längsseiten einander zugewandt sind.

In die Nuten sind Baugruppen 10, die Leiterplatten 11 mit nicht näher dargestellten elektrischen bzw. elektronischen Bauelementen tragen, mit dem oberen und unteren Rand der jeweiligen Leiterplatte 11 eingesetzt. Die Leiterplatten 11 tragen an ihren rückseitigen Enden Messerleisten 12, die in Federleisten 13 eingreifen, wenn die Baugruppe 10 ihre Endposition in den Führungshaltern 8, 9 erreicht hat. Die Federleisten 13 sind an den mittleren Profilschienen 63, 64 des Baugruppenträgers 1 befestigt. Dadurch ergibt sich auf der Rückseite des Baugruppenträgers 1 hinter den Federleisten 13 bis zu einer Rückwand 52 ein abgeschirmter Raum für die Verdrahtung. In besonderen Anwendungsfällen, z. B. beim Einsatz einer geschirmten Busverdrahtung, kann auf das mittlere Schienenpaar 63, 64 verzichtet werden, wodurch die Führungshalter 8, 9 direkt auf den hinteren Profilschienen 5, 6 befestigt werden. Es gibt dann keinen Verdrahtungsraum im Baugruppenträger 1.

Im allgemeinen weist jede Baugruppe 10 eine Frontplatte 14 auf, die bei eingeschobener Leiterplatte 11 mit ihrem oberen und unteren Ende auf den Profilschienen 3 und 4 aufliegt und befestigt werden kann. Die Frontplatte 14 kann auch in speziell abgewandelter Form einen Frontsteckverbinder für den Anschluss von Leitungen bzw. Kabeln an die Bauelemente des Baugruppenträgers aufweisen. Die Frontplatten 14 haben U-förmige Querschnitte.

Wenn die auf den Leiterplatten 11 angeordneten Schaltungen mit hochfrequenten oder sehr hochfrequenten Schwingungen arbeiten, ist es häufig notwendig, den Baugruppenträger 1 abzuschirmen, um das Austreten elektromagnetischer Strahlung zu dämpfen oder zu verhindern. Die metallischen Seitenwände und die metallischen Profilschienen 3 bis 6 eignen sich als Bestandteile eines Abschirmsystems. Die Führungshalter 8, 9 bestehen meist aus Kunststoff, d. h. sie können keine abschirmende Wirkung ausüben. Um die Ober- und die Unterseite des Baugruppenträgers abzuschirmen, sind zwei Abdeckplatten 15, 16 bzw. Abdeckbleche vorgesehen, die zwischen den Profilschienen 3, 4 bzw. 63, 64 verlaufen.

Die Abdeckplatten 15, 16 bestehen aus Metallblech, insbesondere aus Aluminiumblech. Um die Abschirmwirkung zu vervollständigen, sind die Frontplatten 14 der in den Baugruppenträger 1 eingesetzten Baugruppen aus Metall, vorzugsweise aus Aluminium, hergestellt.

Von jeder Frontplatte einer Baugruppe springt ein Steckkontakt 17 in Richtung des jeweiligen Führungshalters 8 vor, dessen Anfang gegen die vordere Stirnseite der Profilschiene 7 zurückgesetzt ist. Auf den Profilschienen 3a, 5 ist ein nicht dargestellter Federkontakt befestigt, in den der Steckkontakt 17 eingreift und damit eine leitende Verbindung zwischen der metallischen Frontleiste 14 bzw. der metallischen Schicht der Frontplatte und der Profilschiene 8 herstellt. Gleichzeitig stabilisiert dieser Federkontakt die Frontplatte in Längsrichtung der Profilschienen und wirkt den Federkräften der Blattfedern 31 entgegen.

Um die abschirmende Wirkung des Baugruppenträgers zu verbessern, werden leitende Verbindungen von Frontplatte zu Frontplatte und von den äusseren Frontplatten zu den Seitenwänden 2, 3 hergestellt. Dies wird durch folgende Mittel erreicht: Von den vertikalen Rändern 18, 19 der Frontplatten 14 ragen jeweils Schenkel 20, 21 nach innen, d. h. gegen die Mitte des Baugruppenträgers 1. Die Schenkel 20, 21 erstrecken sich über die Höhe des Innenraums des Baugruppenträgers 1 und bestehen aus Metall. Der Schenkel 21 weist eine gegen das Innere des Baugruppenträgers sich verjüngende Spitze 22 auf.

In dem Schenkel 20 sind zwei Nuten 23, 24 vorgesehen, von denen die erste Nut 23 zum Inneren der Baugruppe 10 hin, d. h. zum Steckkontakt 17, offen ist, während die zweite Nut 24 zur Frontplatte der benachbarten Leiterplatte hin offen ist. Die beiden Frontplatten 14 grenzen je an einer Seite an die Befestigungswinkel 25, 26 des Baugruppenträgers 1 an. Die Befestigungswinkel 25, 26 sind jeweils mit einer Seitenwand 2, 3 verbunden. Befestigungswinkel 25, 26 und Seitenwand 2 bzw. 3 können auch einstückig ausgebildet werden.

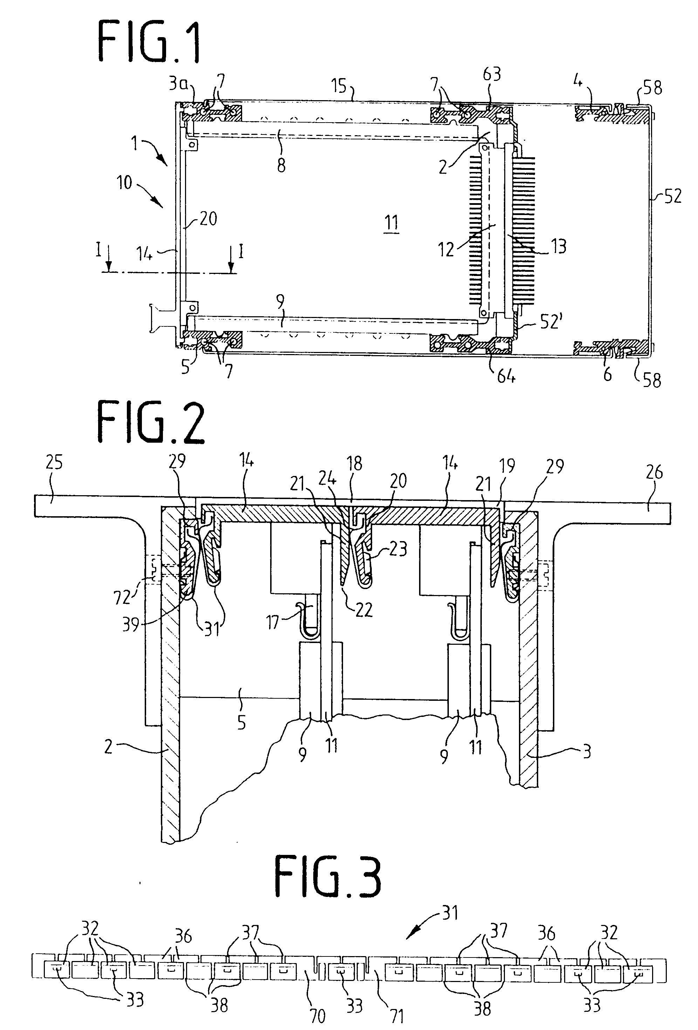

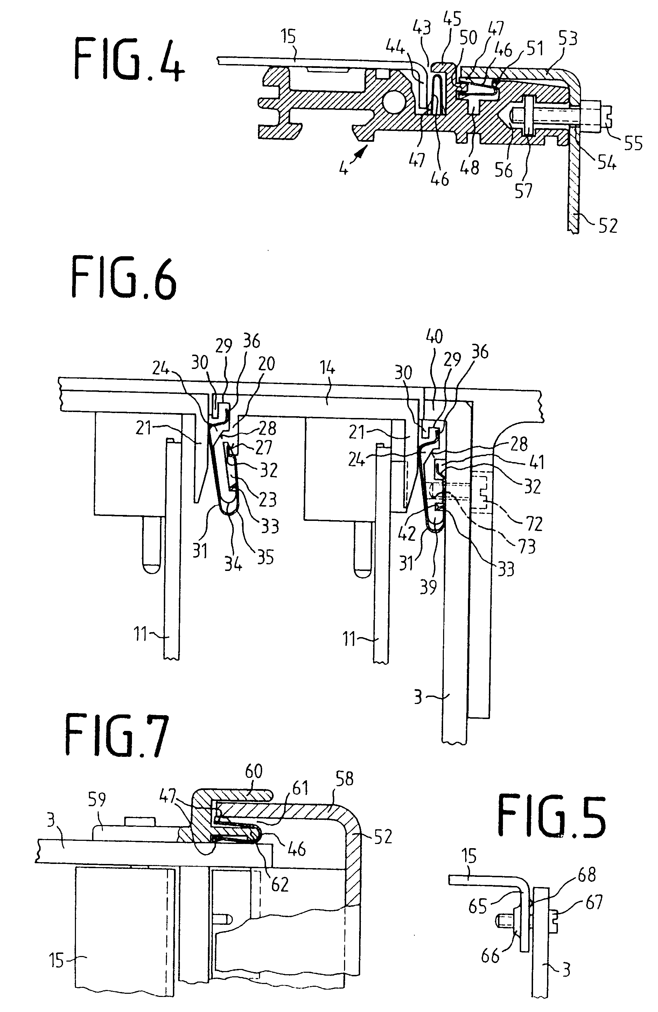

Die Fig. 6 zeigt deutlicher als Fig. 2, dass die Nut 23 nach innen breiter wird. Die Nut 24 hat eine Seitenwand 28, die die Nut 24 in Richtung der oberen Öffnung verbreitert. Die andere Seitenwand 29 der Nut 24 verläuft rechtwinklig zum Nutboden, hat aber am äusseren Rand einen Vorsprung 30.

In die Nut 23 ist eine Blattfeder 31 eingesetzt, die sich über die Höhe des Innenraums des Baugruppenträgers 1 erstreckt. Die Blattfeder 31 hat an einem Längsrand einen hakenförmigen Absatz 32.

Im Abstand vom Absatz 32 sind aus dem Blattfederkörper im Abstand voneinander angeordnete Lappen 33 schräg abgebogen, die z. B. durch Stanzen hergestellt sind. Mit dem Absatz 32 sind jeweils die Blattfedern 31 in die Nuten 23 so eingesetzt, dass der Rand des Absatzes an der schrägen Seitenwand 27 anliegt. Die Lappen 33 legen sich gegen die andere Seitenwand der Nut 23 an. Mittels des Absatzes 32 und der Lappen 33 wird die Blattfeder 31 fest in der Nut 23 gehalten.

Die Blattfeder 31 überragt die dem Inneren des Baugruppenträgers 1 zugewandte Schmalseite 34 des Schenkels 20. Die Schmalseite 34 ist abgerundet. Um die Schmalseite 34, jedoch in einem gewissen Abstand zu dieser, verläuft die Blattfeder 31 in einen Bogen 35. Am anderen Längsrand der Blattfeder ist ein weiterer Absatz 36 vorhanden, der in die Nut 24 hineinragt. Der Rand 37 des Absatzes 36 ragt in die unter dem Vorsprung 30 sich erstreckenden Zone der Nut 24. Unter der Federwirkung spreizen sich die Längsränder auseinander, d. h. der Abstand zwischen den Absätzen 32 und 36 wird grösser. Die Blattfeder 31 weist in Längsrichtung eine erste Reihe von Schlitzen 37, die vom Absatz 36 ausgeht, und eine zweite Reihe von Schlitzen 38 auf, die vom Absatz 27 ausgeht. Die Schlitze 37, 38 sind in Längsrichtung gegeneinander versetzt angeordnet und verlaufen quer zur Längsachse der Blattfeder 31.

Wenn keine Haltefläche in dem Bewegungsbereich der Blattfeder 31 vorhanden ist, biegt sie sich so weit von der Baugruppe nach aussen, bis der Rand des Absatzes 36 am Vorsprung 30 anliegt. Der Vorsprung 30 begrenzt demnach den Federhub auf ein vorgebbares Mass, das sich nach der für Baugruppen vorgesehenen Teilung in Längsrichtung der Profilschienen 3a, 4 usw. richtet. Wenn zwei Baugruppen nebeneinander im Baugruppenträger angeordnet sind, liegt die Blattfeder 31 an der Leiste 22 an. Durch die Geometrie der Blattfeder wird dabei gleichzeitig das Ende der Blattfeder gegen die Seitenwand 27 der Nut 23 gepresst, so dass eine gut leitende Verbindung zwischen den beiden Frontplatten 14 geschaffen wird. Dies bedeutet, dass die Blattfeder 31 eine weiche Federcharakteristik hat. Durch die Blattfeder 31 wird also das Einschieben und Herausziehen von Baugruppen nicht in einer ins Gewicht fallenden Weise erschwert. Trotzdem werden niedrige Übergangswiderstände zwischen den Blattfedern 31 und den Schenkeln 21 erzielt, wodurch sich eine gute Abschirmwirkung ergibt.

Um einen elektrisch gut leitenden Übergang zwischen den Frontplatten und den Seitenwänden 2, 3 zu erzielen, sind Leisten 39 vorgesehen, die in die Ecken zwischen den Seitenwänden 2, 3 und deren frontseitig abgewinkelten Rändern 40 eingefügt sind. Die Leisten 39 haben ebenso wie die Leisten 20 eine Nut 24 mit einer schrägen Seitenwand 28 und eine rechtwinklig zum Nutboden verlaufende Seitenwand 29, an deren äusserem Rand ein Vorsprung 30 parallel zum Nutboden verläuft. Die Nut 24 ist der benachbarten Baugruppe zugewandt.

Auf der der Seitenwand 2 oder 3 zugewandten Seite hat die Leiste 39 zwei parallele Nuten 40, 41, die U-förmig ausgebildet sind. Die Leisten 39 sind für die Halterung von Blattfedern 31 bestimmt. Mit dem Absatz 32 ist eine Blattfeder 31 in die Nut 40 eingesetzt. Die Lappen 33 ragen in die Nut 41. Zwischen den Nuten 40, 41 ist die Blattfeder 31 so fest zwischen Leiste 39 und Seitenwand 2 bzw. 3 eingespannt. Zur Befestigung der Leiste 39 an der Seitenwand 2 bzw. 3 ist eine Schraube 42 vorgesehen, die in eine Bohrung in der Seitenwand 2 oder 3 eingesetzt und in einer Gewindebohrung 43 der Leiste 39 eingeschraubt ist. Es reichen zwei Schrauben 42 für die Befestigung der Leiste 39 aus. In Höhe der Bohrungen in den Seitenwänden 2, 3 sind in den Blattfedern 31 grössere Schlitze 44, 46 als Durchlässe für die Schrauben 42 vorgesehen.

Wenn eine Frontplatte 14 mit ihrem Schenkel 21 der Seitenwand 3 zugekehrt ist, liegt der Schenkel 21 an der Blattfeder 31 an. Dies ist aus Fig. 6 zu ersehen. Aus Fig. 2 ist ersichtlich, dass eine der äusseren Baugruppen mit ihrem Schenkel 20 der Seitenwand 2 gegenübersteht. In diesem Fall liegen zwei Blattfedern 31 aneinander an. Die eine Blattfeder 31 wird von dem Schenkel 20 und die andere von der Leiste 39 gehalten. Die Leiste 39 ist mittels Schrauben 42 an der Seitenwand 2 befestigt.

Zusätzlich zu einer guten Abschirmwirkung hat die oben beschriebene Vorrichtung den Vorteil, dass sich die Baugruppen 1 relativ leicht in ihre Steckplätze einschieben oder daraus entfernen lassen. Durch die Hubbegrenzung der Blattfedern 31 wird verhindert, dass nach dem Herausziehen einer Baugruppe die anderen Baugruppen wegen der in Längsrichtung der Profilschienen 3, 5 wirkenden Federkräfte unzulässig stark beansprucht werden.

Neben einer Verbesserung der Abschirmung des Baugruppenträgers 1 weist die in Fig. 4 gezeigte Anordnung noch Vorteile auf, die darin bestehen, dass in der Höhe des Baugruppenträgers auf der Rückseite der Raum für die Steckverbinder bzw. frontseitigen Anschlüsse nur wenig vermindert wird. Die rückwärtigen Profilschienen 6, 4 haben Nuten 43, in die die abgewinkelten Ränder 44 der Abdeckplatten 15, 16 ragen. An einem oberen Längsrand der jeweiligen Nut 43 befindet sich ein leistenförmiger Vorsprung 45, der von einer Seitenwand der Nut 43 ausgeht.

In die Nuten 43 sind Federn 46 eingesetzt, die einen U-förmigen Querschnitt haben. Nahe an den Enden der Federn 46 sind zackenförmige Vorsprünge 47 vorhanden, die über dem Nutgrund angeordnet sind. Die Vorsprünge 45 halten die Federn 46 in den Nuten 43 zurück. Die Federn 46 sind mit den zackenförmigen Vorsprüngen gegen die Ränder 44 angedrückt und stellen damit eine elektrisch gut leitende Verbindung zwischen den Abdeckplatten 15, 16 und den Profilschienen 4, 6, 63 und 64 her.

Eine weitere Nut 48 befindet sich in Richtung der rückseitigen Endes des Baugruppenträgers 1 neben der Nut 43. Die Nut 48 hat eine von einer Seitenwand vorspringende Leiste 50 und eine von der gegenüberliegenden Seitenwand an deren oberem Rand vorspringende Leiste 51. In die Nut 48 ist eine Feder 46 derart eingesetzt, dass sich die freien Enden beiderseits der Leiste 50 befinden. Die Wölbung der Feder 46 befindet sich im Raum unterhalb der Leiste 51.

Der Baugruppenträger 1 wird durch eine rückwärtige Platte 52 abgeschirmt, die oben und unten abgewinkelte Ränder 53 hat. Die abgewinkelten Ränder 53 ragen über die Öffnungen der Nuten 48 hinweg, wodurch die Federn 46 mit den Vorsprüngen an die Innenseiten der Ränder 53 angedrückt werden. Hierdurch wird eine elektrisch gut leitende Verbindung zwischen der Platte 52 und den Profilschienen 4, 6, 63 und 64 erzielt. Die Platten 53 weisen in Höhe der Profilschienen 63, 64 Bohrungen 54 auf, in die Schrauben 55 eingesetzt sind, die in Nuten 56 der Profilschienen 63, 64 ragen. Die Nuten 56 haben kreuz- bzw. T-förmige Querschnitte und enthalten Gewindeleisten 57 oder Gleitmuttern, in die die Schrauben 55 eingeschraubt sind.

Die Platte 52 hat seitliche, die Seitenwände 2, 3 ein Stück umgreifende Ränder. An den äusseren Flächen der Seitenwände 2, 3 sind Profilleisten 59 angeschraubt, die senkrecht verlaufen. Die Profilleisten 59 weisen treppenstufenförmige Absätze auf, die Hohlräume 61 mit den Seitenwänden 2, 3 umgeben, in die die Ränder 58 hineinragen. In diese Hohlräume ragen weiterhin Vorsprünge 62 hinein, die von den Profilleisten 59 ausgehen.

Um die Vorsprünge 62 sind Federn 46 gelegt, deren Vorsprünge 47 einerseits an die Ränder 58 und andererseits an die Wände 2, 3 angedrückt sind, so dass eine elektrisch gut leitende Verbindung zwischen der Platte 52 und den Seitenwänden 2, 3 geschaffen wird.

Die Abdeckplatten 15, 16 haben abgewinkelte seitliche Ränder 61, die sich ein Stück mit den Seitenwänden 2, 3 überlappen. Die Ränder 61 sind vorzugsweise mit Durchzügen 62 für gewindeformende Schrauben versehen, da die Abdeckplatten in der Regel dünnwandig sind. Über Bohrungen in den Seitenwänden 2, 3 werden die Ränder 61 der Abdeckplatten 15, 16 miteinander verschraubt. Zwischen den Gewindebohrungen und den Kanten der Abdeckplatten 15, 16 sind Noppen 64 vorgesehen, die gegen die Seitenwände 2, 3 gedrückt werden, wenn die Schrauben 63 angezogen werden. So wird eine definierte gut leitende Verbindung zwischen der Abdeckplatte 15, 16 und den Seitenwänden 2, 3 geschaffen. Der oben beschriebene Baugruppenträger 1 ist somit allseitig gut abgeschirmt. Die rückwärtige Stecker- bzw. Verdrahtungsplatte ist darüberhinaus leicht zugänglich, ohne dass die Mittel zur Abschirmung den für Anschlüsse vorgesehenen Raum vermindern.

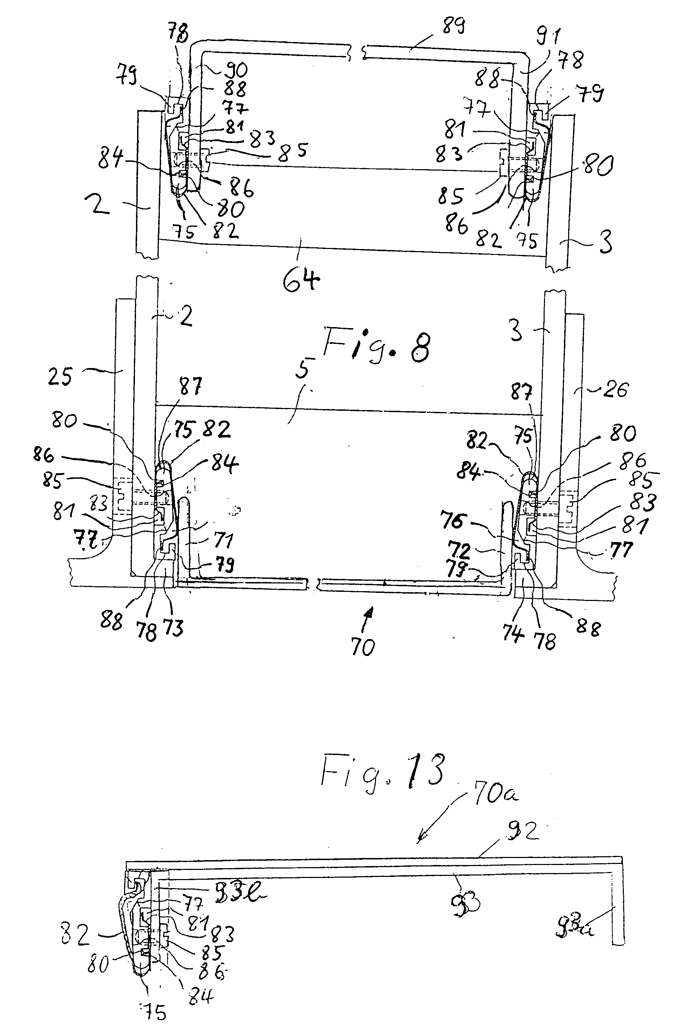

Die vordere Öffnung des Baugruppenträgers 1 kann auch durch eine Frontplattte 70 aus Metall abgedeckt werden. Es ist auch möglich, mehrere Frontplatten, die nur je einen Teil der Öffnung des Baugruppenträgers 1 bedecken, nebeneinander anzuordnen. Die Fig. 8 zeigt eine solche Frontplatte 70. Die Frontplatte 70 hat die Form einer ebenen Platte mit an den Seiten rechtwinklig abgewinkelte Rändern 71, 72, die ins Innere des Baugruppenträgers 1 gerichtet sind. Die Seitenwände 2, 3 sind an der Öffnung des Baugruppenträgers 1 je mit rechtwinklig abgewinkelten Enden 73, 74 versehen, die einander zugewandt sind.

Um einen elektrisch gut leitenden Übergang zwischen der Frontplatte 70 und den Seitenwänden 2, 3 zu erzielen, sind Leisten 75 vorgesehen, die in die Ecken zwischen den Seitenwänden 2, 3 und deren frontseitig abgewinkelten Rändern 73, 74 eingefügt sind.

Die Leisten 75 haben eine Nut 76 mit einer schrägen Seitenwand 77 und eine rechtwinklig zum Nutboden verlaufende Seitenwand 78, an deren äusserem Rand ein Vorsprung 79 parallel zum Nutboden verläuft. Die Nuten 76 der Leisten 75 sind einander zugewandt.

Auf der der Seitenwand 2 oder 3 zugewandten Seite hat die Leiste 75 zwei parallele Nuten 80, 81, die U-förmig ausgebildet sind. Die Leisten 75 sind für die Halterung von Blattfedern 82 bestimmt. Mit ihrem Absatz 83 ist die Blattfeder 82 in die Nut 80 eingesetzt. Von der Blattfeder 82 vorspringende Lappen 84 ragen in die Nut 81. Zwischen den Nuten 80, 81 ist die Blattfeder 82 fest zwischen Leiste 75 und Seitenwand 2 bzw. 3 eingespannt. Zur Befestigung der Leiste 75 an der Seitenwand 2 bzw. 3 ist eine Schraube 85 vorgesehen, die in eine Bohrung in der Seitenwand 2 oder 3 eingesetzt und in einer Gewindebohrung 86 der Leiste 75 eingeschraubt ist. Es reichen zwei Schrauben für die Befestigung der Leiste 75 aus. In Höhe der Bohrungen in den Seitenwänden 2, 3 sind in den Blattfedern 82 grössere, nicht dargestellte Schlitze als Durchlässe für die Schrauben 85 vorgesehen.

Die Lappen 84 sind im Abstand vom jeweiligen Absatz 83 durch Stanzen hergestellt. Mit dem Absatz 83 sind jeweils die Blattfedern 82 in die Nuten 80 so eingesetzt, dass der Rand des Absatzes an der schrägen Seitenwand 77 anliegt. Die Lappen 84 legen sich gegen die andere Seitenwand der Nut 80 an. Mittels des Absatzes 85 und der Lappen 84 wird die Blattfeder 81 fest in der Nut 80 gehalten.

Die Blattfedern 82 überragen die dem Inneren des Baugruppenträgers 1 zugewandten Schmalseiten 87 der Ränder 71, 72. Die Schmalseiten 87 sind abgerundet. Um die Schmalseiten 87, jedoch in einem gewissen Abstand zu dieser, verläuft die Blattfeder 82 in einen Bogen. Am anderen Längsrand der Blattfeder 82 ist ein Absatz 88 vorhanden, der in die Nut 76 hineinragt. Der Rand des Absatzes 88 ragt in die unter dem Vorsprung sich erstreckenden Zone der Nut 76.

Unter der Federwirkung spreizen sich die Längsränder auseinander, d. h. die Blattfeder 82 ragt über die Leiste 75 hinaus, bis der Absatz an der Seitenwand der Nut 76 anliegt.

Die Blattfeder 82 ist in gleicher Weise wie die Blattfeder 31 aufgebaut und weist in Längsrichtung eine erste Reihe von Schlitzen auf. Die Schlitze 37, 38 sind in Längsrichtung gegeneinander versetzt angeordnet und verlaufen quer zur Längsachse der Blattfeder 82.

Wenn keine Haltefläche in dem Bewegungsbereich der Blattfeder 82 vorhanden ist, biegt diese sich so weit von der Leiste 75 nach aussen, bis der Rand des Absatzes 88 innen am Vorsprung 79 anliegt. Der Vorsprung 79 begrenzt demnach den Federhub auf ein vorgebbares Mass, das sich nach der für Baugruppen versehenden Teilung in Längsrichtung der Profilschienen 5, 6 usw. richtet. Wenn die Frontplatte 70 im Baugruppenträger 1 angeordnet ist, liegen die Blattfedern 82 an den Rändern 71, 72 an. Die Blattfeder 82 wird gegen die Ränder 71, 72 gepresst, so dass eine gut leitende Verbindung zwischen der Frontplatte 70 und den Seitenwänden 2, 3 geschaffen wird. Dies bedeutet weiterhin dass die Blattfedern 82 weiche Federcharakteristiken haben. Durch die Blattfeder 82 wird also das Einschieben und Herausziehen der Frontplatte nicht in einer ins Gewicht falenden Weise erschwert. Trotzdem werden niedrige Übergangswiderstände zwischen den Blattfedern 82 und den Rändern 71, 72 erzielt, wodurch sich eine gute Abschirmwirkung ergibt.

Der Baugruppenträger 1 wird durch eine rückwärtige Haube 89 abgeschirmt, die oben und unten abgewinkelte Ränder 90, 91 hat. Die abgewinkelten Ränder 90, 91 ragen in die Öffnung zwischen den Seitenwänden 2, 3 hinein. Auf den nach aussen gerichteten Flächen der Ränder 90, 91 sind Leisten 75 befestigt, die den gleichen Aufbau haben wie die an den Seitenwänden 2, 3 befestigten Leisten. Es werden auch gleich Schrauben zum Befestigen der Leisten verwendet. Zwischen den Leisten 75 und den äusseren Flächen der Ränder 90, 91 sind in gleicher Weise wie an den Seitenwänden 2, 3 Blattfedern 82 eingespannt, die die in Fig. 3 gezeigte Form haben. Wenn sich die Ränder 90, 91 mit den Seitenwänden 2, 3 unter Freilassung des für die Leisten 75 und die Blattfedern 82 vorgesehenen Zwischenraums überlappen, legen sich die Blattfedern 82 an die Seitenwände 2, 3 an.

Hierdurch werden gut leitende Verbindungen zwischen den Seitenwänden 2, 3 und der Platte 89 hergestellt, d. h. es wird eine gute Abschirmwirkung erzielt. Hinsichtlich der Federcharakteristik zeigen die Blattfedern 82 an der Platte 89 die gleichen Wirkungen und Vorteile, die im Zusammenhang mit der Frontplatte 70 erläutert sind.
Die Frontplatte 70a weist eine ebene vordere Platte 92 auf, an der eine rückwärtige Platte 93 mit unter rechten Winkeln abgewinkelten Rändern befestigt ist. Die Platte 92 besteht aus Aluminium.

Die Platte 93 besteht aus verzinktem Stahl oder Eisen. Während der Rand 93a mit dem Rand der Platte 92 fluchtet, ist der Rand 93b gegen den Rand der Platte 92 ein Stück zurückgesetzt. Das Mass der Zurücksetzung entspricht der Stärke einer Leiste 86 und einer Blattfeder 82, die mit der Leiste 86 so am Rand 93 befestigt ist, dass die Ecke zwischen dem Rand der Platte 93 und dem überstehenden Rand der Platte 92 von der Leiste 75 eingenommen wird. Die Befestigung der Leiste 75 am Rand 93b entspricht derjenigen der Leisten 86 an den Rändern 90, 91. Die Blattfeder 82 berührt in Abhängigkeit von der Lage der mit der Frontplatte 70a bestückten Steckbaugruppe in Breitenrichtung des Baugruppenträgers 1 entweder eine Blattfeder 82 an einer Seitenwand oder einen Rand 93a der Frontplatte 70a einer im Baugruppenträger 1 benachbarten Steckbaugruppe. Der Baugruppenträger 1 für die Aufnahme von elektrischen oder elektronischen Baugruppen enthält zwei ebene, rechteckige Seitenwände 2, 3, die über Prüfilschienen 3a, 4, 5, 6 miteinander verbunden sind.

Die Profilschienen 3a, 5 befinden sich an der Vorderseite des Baugruppenträgers 1, während die Profilschienen 4, 6 an der rückwärtigen Seite des Baugruppenträegers 1 angeordnet sind. Die Profilschienen 3a bis 6 sind gleich lang oder verlaufen quer zu den Seitenwänden 2, 3. Die Profilschienen 3a, 4, 5 und 6 weisen an ihren stirnseitigen Enden jeweils nicht näher dargestellte Gewindelöcher auf und sind mit Stahlschrauben an den Seitenwänden 2, 3 befestigt.

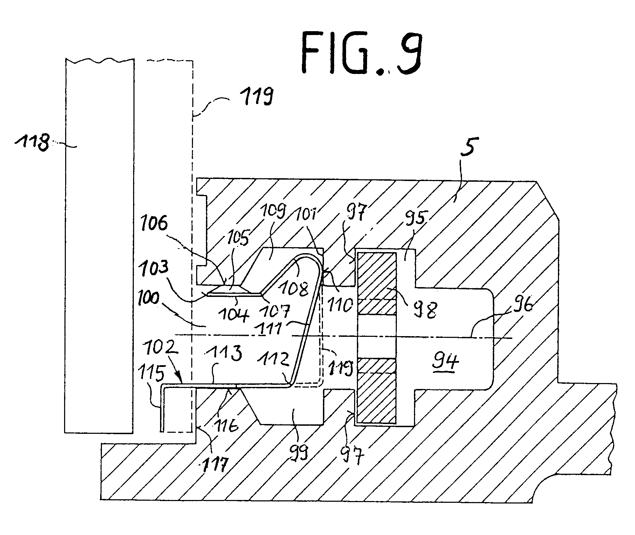

Die Profilschienen 3a, 63, 5 und 64 haben in ihrem vorderen, der Vorderseite des Baugruppenträgers 1 zugewandten Teil das in Fig. 9 dargestellte Querschnittsprofil, das anhand der unteren Profilschiene 5 näher beschrieben wird.

Die Profilschiene 5 ist mit einer länglichen Nut 94 versehen, die sich über die gesamte Länge erstreckt. Die Nut 94 ist auf der Vorderseite der Profilschiene offen. In der Nut 94 befindet sich ein Abschnitt 95 mit grösserem Querschnitt, der symmetrisch zur Mittelebene 96 der Nut verläuft. Durch die Querschnittsvergrösserung werden zwei Auflageflächen 97 gebildet, die für Gleitmuttern oder Gewindeleisten bestimmt sind, von denen eine Gewindeleiste 98 in Fig. 9 dargestellt ist. Es kann sich dabei um eine über die ganze Länge der Nut 94 verlaufende Gewindeleiste oder um einzelne, aneinandergrenzende Gewindeleistenabschnitte handeln. Die Nut 94 hat zusätzlich einen verbreiterten Abschnitt 99, der symmetrisch zur Mittelebene 96 zwischen der Zone 95 und der Öffnung 100 der Nut 94 liegt. Der Abschnitt 99 erstreckt sich ebenfalls quer zur Tiefe der Nut 94. Durch den Abschnitt 99, der quer zur Tiefenrichtung der Nut 94 eine grössere Strecke einnimmt als die Breite der Öffnung 100 der Nut 94, entstehen in der Nut 94 zusätzliche Wandflächen, von denen eine Wandfläche 101 eine besondere Bedeutung hat. Die Wandfläche 101 wirkt mit einer im folgenden näher beschriebenen Blattfeder 102 zusammen, die in die Nut 94 eingesetzt ist und im folgenden näher beschrieben wird. Die Blattfeder 102 erstreckt sich zumindest über einen Teil der Länge der Nut 94. Es können zwei oder mehr Blattfedern 102 nebeneinander in der Nut 94 angeordnet sein, um die Nut 94 zwischen den Seitenwänden 2, 3 vollständig zu bestücken. An einem Ende 103 der Blatfeder 102 beginnt ein ebener Bereich 104. Vom Bereich 104 springen abgewinkelte Noppen 105 vor, die an der einen Nutwand 106 zwischen der Öffnung 100 und dem Abschnitt 93 unter der beim Einsetzen der Blattfeder 102 in die Nut 94 durch elastische Verformung erzeugten Federspannung anliegen. Der Bereich 104 erstreckt sich in den Abschnitt 99 hinein bis zu einer Knickstelle 107, an der ein Bogen 108 beginnt, der in die eine auf einer Seite der Mittelebene 96 liegende Hälfte 109 des Abschnitts 99 hineinragt. Diese Hälfte weist die Wandfläche 101 auf. Der Bogen 108 erstreckt sich bis zur Wandfläche 101, an der die Blattfeder 102 bei Verformung der Feder 102 anliegt. An der Auflagestelle 110 zwischen dem Bogen 108 der Blattfeder 102 und Wandfläche 101 beginnt ein gerader Abschnitt 111, der sich über die Breite der Nut 94 erstreckt und in eine Krümmung 112 übergeht, die etwa in Höhe der anderen Wand 113 der Nut 94 liegt. Die Krümmung 112 befindet sich im Bereich des Abschnitts 99 und bei Formänderungen der Blattfeder 102 in Richtung der Tiefe der Nut 94 verschoben werden.

Ab der Krümmung 112 geht die Blattfeder 102 in einen weiteren geraden Abschnitt 113 über, der über die Öffnung 100 hinausragt und an den sich das andere Ende der Blattfeder 102 in Form eines abgewinkelten Streifens 115 anschliesst. Der Abschnitt 113 liegt unter Federvorspannung an der Wand 116 an. Der Streifen 115 ist nach aussen, d. h. der Öffnung 100, abgewinkelt.

Die Feder 102 ist so geformt, dass in entspannter Stellung der Bereich 104 und der Abschnitt 113 weiter voneinander entfernt sind als die Nut 94 breit ist. Durch Zusammendrücken der Feder 102 zwischen dem Bereich 104 und dem Abschnitt 113 lässt sich die Feder 102 in die Nut 94 einsetzen, wobei sie nach dem Einsetzen unter Federvorspannung die in Fig. 9 dargestellte Form annimmt. In dieser Form herrscht zwischen dem Streifen 115 und der an die Nut 94 angrenzenden äusseren Profilschienenwand 117 ein gewisser Abstand.

In Fig. 9 ist ein Teil einer Frontplatte 118 in einem gewissen Abstand von der Profilschienenwand 117 dargestellt. Weiterhin ist in Fig. 9 mit gestrichelten Linien 119 die Lage des Teils der Frontplatte 118 in der Endlage der die Frontplatte 118 enthaltenden Baugruppen im Magazin dargestellt. Die Baugruppe ist in der Zeichnung nicht näher dargestellt.

In der mit 119 bezeichneten Endlage der Frontplatte 118 hat die Blattfeder 102 eine andere Form. Der Streifen 115 befindet sich zwischen der Profilleistenwand 117 und der Frontplatte 118. Der Abschnitt 111 und die Krümmung 112 sowie der Abschnitt 113 befinden sich tiefer in der Nut 94. Die Stellung des Abschnitts 111 und der Krümmung 112 ist in Fig. 9 durch die gestrichelte Linie 119 dargestellt. Die Verformung der Blattfeder 102 in der Endlage der Frontplatte 118 bewirkt eine Federkraft, die auf die Frontplatte 118 ausgeübt wird. Durch diese Anpresskraft wird ein niederohmiger elektrischer Übergangswiderstand zwischen Blattfeder 102 und Frontplatte 118 hervorgerufen. Ein weiterer niederohmiger Übergangswiderstand ergibt sich an den Auflagen des Bogens 108 an der Wandfläche 101.
Die Blattfeder 102 ist in gleichmässigen Abständen mit Schlitzen 120 versehen, die nahe an der Auflagestelle 110 auf der der Mittelebene 96 zugewandten Seite beginnen und sich bis zu dem Ende des Streifens 115 erstrecken.

Die Schlitze 120 sind in der Breite den Querschnitten der in die Gewindeleiste 98 einfügbaren Schrauben angepasst, so dass die Schrauben durch die Schlitze mit der Gewindeleiste 98 verbunden werden können. Die Abstände zwischen den Schlitzen 120 sind auf die Teilung zwischen den Mittel der Gewindebohrungen der Gewindeleiste 98 abgestimmt. Im Bereich der Leiste 115 enden die Schlitze 120 an Engstellen 121, so dass die Leisten 115 grossflächig an den Frontplatten 118 anliegen. Damit werden in regelmässigen Abständen elektrisch leitende Verbindungen zwischen den metallischen Frontplatten und der Profilschiene über die Blattfeder 102 erzeugt. Hierdurch ergibt sich an den Enden der Frontplatten 118 eine gute Abschirmwirkung in bezug auf Störfelder.

Zwischen der Auflagestelle 110 und der Leiste 115 liegt eine relativ lange Strecke, die für die Verformung der Blattfeder 102 verfügbar ist. Deshalb hat die Blattfeder 102 eine weiche Federcharakteristik, wodurch das Einschieben der Baugruppe in ihre Magazinendlage nicht in einer ins Gewicht fallenden Weise beeinflusst wird.

Die Fig. 11 zeigt eine andere Ausführungsform einer Blattfeder 122, die in die Nut 94 einsetzbar ist, im Querschnitt. Die Blattfeder 122 ist teilweise gleich ausgebildet wie die Blattfeder 102. Übereinstimmung zwischen den Blattfedern 102, 122 herrscht in bezug auf den ebenen Bereich 104, von dem Noppen 105 vorspringen, und in bezug auf die Knickstelle 107, den Bogen 108 und den Abschnitt 111. Am Ende des Abschnitts 111 geht die Blattfeder 122 in verschieden geformte Lappen 123, 124 über, die sich in Abständen voneinander in Längsrichtung der Blattfeder 122 abwechseln.

Der Lappen 124 geht von einer Krümmungsstelle 125 aus und enthält einen nicht näher bezeichneten geraden Abschnitt, der bei in eine Nut 94 eingesetzter Blattfeder 122 im Abstand von der Wand verläuft und in einen abgewinkelten Abschnitt 130 übergeht, der aus der Nut 94 herausragt. Der Lappen 123 geht von einer Krümmungsstelle 126 aus, die, in Längsrichtung des Abschnitts 111 gesehen, hinter der Krümmungsstelle 125 liegt. An die Krümmungsstelle 126 schliesst sich ein ebener Abschnitt an, der nicht näher bezeichnet ist.

Wenn die Blattfeder 122 in eine Nut 94 einer Profilschiene eingesetzt ist, sind die Auflageflächen der Noppen und der Krümmung 108 ebenso wie bei der Blattfeder 102 vorhanden. An der Wand liegt nur der Lappen 123 an, während der Lappen 124 mit dem Abschnitt 130 aus der Nut herausragt. Wird eine Frontplatte gegen den Abschnitt 126 gedrückt, dann verschiebt sich der Lappen 124 ins Nutinnere, wobei eine Formänderung der Blattfeder 122 auftritt. Durch die Verschiebung der Lappen 124 können sich auch die Lappen 123 auf der Wand verschieben. Die Reibungskräfte zwischen der Blattfeder 122 und der Wand sind durch die Form besonders klein, so dass sich die Lappen 124 nach der Entfernung der Frontplatte wieder aus der Nut 94 leicht herausbewegen. Die Lappen 123 ragen nicht aus der Nut 94 heraus. In bezug auf die Wand haben die Lappen 123, 124 verschiedenes Niveau.

## Patentansprüche

1. Baugruppenträger mit zwei metallischen Seitenwänden, zwischen denen an den vier Ecken jeweils Profilschienen aus Metall verlaufen, die an den Seitenwänden befestigt sind und Führungshalter tragen, in denen Baugruppen angeordnet sind, wobei eine obere und/oder eine untere metallische Abdeckplatte jeweils elektrisch leitend mit den vorderen und rückwärtigen Profilschienen und den Seitenwänden verbunden sind und wobei insbesondere die metallischen oder metallisierten Frontplatten der Baugruppen U-förmig ausgebildet sind und einen ersten Schenkel mit einer Blattfeder und einen zweiten Schenkel aufweisen, der als Kontaktfläche für die leitende Verbindung mit der Blattfeder des ersten Schenkels der im Baugruppenträger benachbarten Frontplatte ausgebildet ist,
**dadurch gekennzeichnet**,
dass eine Blattfeder (31) in einem Bogen (35) um die der Frontplatte (14) abgewandte Schmalseite (35) des ersten Schenkels (20) im Abstand zu dieser Schmalseite (35) verläuft und auf der der benachbarten Baugruppe abgewandten Seite des ersten Schenkels (20) in eine Nut (23) eingesetzt und kontaktiert ist und dass der der benachbarten Baugruppe zugewandte Teil der Blattfeder (31) einen Absatz (36) aufweist, der in eine die Bewegung in Richtung der benachbarten Baugruppe begrenzte Nut (29) ragt.

2. Baugruppenträger nach Anspruch 1,
**dadurch** **gekennzeichnet**,
dass die im ersten Schenkel (20) auf der benachbarten Baugruppe abgewandten Seite angeordnete Nut (23) eine Seitenwand (27) enthält, durch die der Querschnitt der Nut (23) in Richtung des Nutgrunds erweitert wird, dass an die Seitenwand (27) ein Absatz (32) der Blattfeder (31) angedrückt ist und dass von der Blattfeder (31) vorspringende Lappen (33) gegen die andere Seitenwand angelehnt sind.

3. Baugruppenträger nach Anspruch 1 oder 2,
**dadurch** **gekennzeichnet**,
dass auf der Innenseite jeder Seitenwand (2, 3) am vorderen Ende zwischen der oberen und unteren Profilschiene (8, 5) eine Leiste (39) befestigt ist, und dass zwischen der Seitenwand (2, 3) und der Leiste (39) eine Blattfeder (31) eingespannt ist, die in einem Bogen um eine Schmalseite der Leiste (39) verläuft und auf ihrer der Seitenwand (2, 3) entgegengesetzten Seite einen Absatz (36) aufweist, der in eine der Bewegung in Richtung der benachbarten Baugruppe begrenzende Nut (29) ragt.

4. Baugruppenträger nach einem oder mehreren der vorhergehenden Ansprüche,
**dadurch** **gekennzeichnet**,
dass die rückwärtigen Profilschienen jeweils eine nach oben oder unten offene Nut (48) mit einer Feder (46) aufweisen, die gegen den die Ecke der Profilschiene umgreifenden, abgewinkelten Rand (53) einer rückwärtigen Abdeckplatte (52) angedrückt ist.

5. Baugruppenträger, insbesondere nach einem oder mehreren der vorhergehenden Ansprüche,
**dadurch gekennzeichnet**,
dass die Frontplatte (70) abgewinkelte seitliche Ränder (71, 72) hat, und dass zwischen den Seitenwänden (2, 3) und den diese innen ein Stück überlappenden Rändern (71, 72) Blattfedern (82) angeordnet sind, die zwischen eingespannten Enden und quer zu den Seitenwänden (2, 3) innerhalb von Anschlägen auslenkbaren Enden Bögen aufweisen, mit denen die Blattfedern V- oder U-förmig umgelenkt werden.

6. Baugruppenträger nach einem oder mehreren der vorhergehenden Ansprüche,
**dadurch** **gekennzeichnet**,
dass jeweils eine Blattfeder (82) auf jeder Innenseite (2, 3) des Baugruppenträgers eingespannt ist.

7. Baugruppenträger nach einem oder mehreren der vorhergehenden Ansprüche,
**dadurch** **gekennzeichnet**,
dass Blattfedern (82) jeweils an einem Ende zwischen einer Leiste (75) und einer Auflagefläche eingespannt sind und in Bögen um die Schmalseiten der Leisten (75) V- oder U-förmig geführt sind und das die Blattfedern (82) mit den anderen Enden in Nuten (76) der Leisten (75) ragen, deren Weite die Auslenkung der Blattfedern (82) zwischen zwei Endlagen bestimmt.

8. Baugruppenträger nach einem oder mehereren der vorhergehenenden Ansprüche,
**dadurch** **gekennzeichnet**,
dass eine Frontplatte (70a) aus einer vorderen ersten Platte (92) und einer inneren, zweiten Platte (93) besteht, die abgewinkelte Ränder (93a, 93b) aufweist, von denen ein Rand (93a) mit dem Rand der vorderen Platte (92) fluchtend angeordnet ist und der zweite Rand (93b) gegen den Rand der vorderen Platte (92) in Richtung der Plattenmitte um die Stärke der Leiste (75) zurückgesetzt ist, die am abgewinkelten Rand unter Einspannung einer Blattfeder (82) befestigt ist, die einen Bogen um den der Vorderseite der Frontplatte (70) abgewandten Rand der Leiste (75) macht und mit einem gegen die Plattenmitte abgewinkelten Ende in eine Nut (76) der Leiste (75) ragt, die die Auslenkung der Feder senkrecht zum abgewinkelten Ende der inneren Platte begrenzt.

9. Baugruppenträger nach einem oder mehreren der vorhergehenden Ansprüche,
**dadurch** **gekennzeichnet**,
dass an der rückwärtigen Seite des Baugruppenträgers (1) eine im Quer- und Längsschnitt U-förmige Haube (89) befestigt ist, an deren abgebogenen Seitenrändern (90, 91) jeweils Leisten (75) befestigt sind, die mit den Seitenrändern (90, 91) Blattfedern (82) verbinden, die an den Seitenwänden (2, 3) des Baugruppenträgers (1) anliegen und in Bögen um die dem Baugruppenträger (1) zugewandten Enden der Leisten (75) verlaufen und in Richtung der Haubenmitte abgewinkelte Enden haben, die in Nuten (76) der Leisten (75) ragen, die die Auslenkung der Blattfedern quer zu den Seitenwänden (2, 3) begrenzen.

10. Baugruppenträger, insbesondere nach einem oder mehreren der vorhergehenden Ansprüche,
**dadurch** **gekennzeichnet**,
dass die obere und untere Profilschiene (5, 3a) jeweils eine zur Vorderseite des Baugruppenträgers (1) hin offene Nut (94) aufweist, die einen ersten, dem Nutgrund benachbarten Abschnitt (95) mit breiteren Querschnitt für mindestens eine Gewindeleiste (98) oder für Gleitmuttern und einen zweiten, zwischen dem ersten Abschnit (95) und der Öffnung (100) der Nut (94) angeordneten Abschnit (99) mit verbreitertem Querschnitt aufweist und dass im zweiten Abschnitt (99) eine Blattfeder (102) unter Federvorspannung angeordnet ist, die eine Auflagestelle (110) an einem Wandabschnitt (101) des Abschnitts (99) und einen Abschnitt (113) aufweist, der unter Federvorspannung in Richtung der Nuttiefe verschiebbar ist und ausserhalb der Nut (94) in einen abgewinkelten Streifen (115) übergeht, der in die der Öffnung (100) der Nut (94) entgegengesetzte Richtung ragt.

11. Baugruppenträger nach einem oder mehreren der vorhergehenden Ansprüche,
**dadurch** **gekennzeichnet**,
dass sich die Aussparungen im Abstand von Gewindebohrungen in einer im ersten Abschnitt (95) angeordneten Gewindeleiste (98) über die abgewinkelten Enden der Blattfeder (102) erstrecken.

12. Baugruppenträger nach einem oder mehreren der vorhergehenden Ansprüche,
**dadurch** **gekennzeichnet**,
dass die Blattfeder (102) an einem Ende einen ebenen Bereich (104) enthält, der in einen dem erweiterten Abschnitt (99) angepassten Bogen (108) übergeht, der sich in einem geraden Abschnitt (111) fortsetzt, der nach einer der Breite der Nut (94) entsprechenden Strecke gekrümmt in einen weiteren geraden Abschnitt (113) übergeht, an den sich das abgewinkelte Ende anschliesst.

13. Baugruppenträger nach einem oder mehreren der vorhergehenden Ansprüche,
**dadurch** **gekennzeichnet**,
dass der ersten und der zweite Abschnitt (95, 99) symmetrisch zu einer durch die Mitte der Nut (94) verlaufenden Ebene (96) ausgebildet sind.

14. Baugruppenträger nach einem oder mehreren der vorhergehenden Ansprüche,
**dadurch** **gekennzeichnet**,
dass von dem ebenen Bereich (104) Noppen (105) vorspringen, die an einer Wand (106) der Nut (94) anliegen.

15. Baugruppenträger nach einem oder mehreren der vorhergehenden Ansprüche,
**dadurch** **gekennzeichnet**,
dass die Blattfeder (102) eine weitere Auflagestelle an einer Wand (106) der Nut (94) aufweist.

16. Baugruppenträger nach einem oder mehreren der vorhergehenden Ansprüche,
**dadurch** **gekennzeichnet**,
dass vom Ende des Abschnitts (111) in unterschiedlichem Niveau zum Abschnitt (111) verschieden geformte Lappen (123, 124) ausgehen, die sich in Längsrichtung der Blattfeder (122) abwechseln, dass die eine Art von Lappen (124) abgewinkelte Abschnitte (126) enthält, die über die Nut (94) hinausragen, und dass die andere Art von Lappen (123) mit ihren Enden innerhalb der Nut (94) liegen.

## Claims

1. Assembly rack with two metallic side walls, between which respective profile rails of metal extend at each of the four corners, which rails are fastened at the side walls and carry guide holders, in which assemblies are arranged, wherein an upper and/or a lower metallic cover plate is respectively electrically conductively connected with each of the front and rear profile rails and the side walls and wherein in particular the metallic or metallised front plates of the assemblies are constructed in U-shape and display a first limb with a leaf spring and a second limb which is constructed as contact surface for the conductive connection with the leaf spring of the first limb of the front plate adjacent in the assembly rack, characterised thereby, that one leaf spring (31) runs in an arc (35) around that narrow side (35) of the first limb (20), which is remote from the front plate (14), and at a spacing from this narrow side (35) and is inserted into a groove (23) and made contact with on that side of the first limb (20), which is remote from the neighbouring assembly, and that that part of the leaf spring (31), which faces the neighbouring assembly, displays a step (36), which projects into a groove (29) limiting the movement in the direction of the neighbouring assembly.

2. Assembly rack according to claim 1, characterised thereby, that the groove (23), which is arranged in the first limb (20) on the side remote from the neighbouring assembly, contains a side wall (27), by which the cross-section of the groove (23) is widened in the direction of the base of the groove, that a step (32) of the leaf spring (31) is urged against the side wall (27) and that lobes (33) projecting from the leaf spring (31) are made to lean against the other side wall.

3. Assembly rack according to claim 1 or 2, characterised thereby, that a strip (39) is fastened between the upper and lower profile rail (8, 5) at the front end on the inward side of each side wall (2, 3) and that a leaf spring (31), which extends in an arc around the narrow side of the strip (39) and on its side opposite the side wall (2, 3) displays a step (36), which projects into a groove (29) limiting the movement of the direction of the neighbouring assembly, is clamped in between the side wall (2, 3) and the strip (39).

4. Assembly rack according to one or more of the preceding claims, characterised thereby, that the rear profile rails each display an upwardly or downwardly open groove (48) with a spring (46), which is urged against the rim (53), which is bent over and encompasses the corner of the profile rail, of a rear cover plate (52).

5. Assembly rack, in particular according to one or more of the preceding claims, characterised thereby, that the front plate (70) has bent-over lateral rims (71, 72) and that leaf springs (82), which display arcs, by which the leaf springs are deflected in V-shape or U-shape, between clamped ends and ends that are deflectable within abutments and transversely to the side walls (2, 3), are arranged between the side walls (2, 3) and the rims (71, 72) overlapping these inwardly by an amount.

6. Assembly rack according to one or more of the preceding claims, characterised thereby, that a respective leaf spring (82) is clamped in on each inward side (2, 3) of the assembly rack.

7. Assembly rack according to one or more of the preceding claims, characterised thereby, that leaf springs (82) are each clamped in at one end between a strip (75) and a bearing surface and led in V-shape or U-shape around the narrow sides of the strips (75) in arcs and the leaf springs (82) project by the other ends into grooves (76) of the strips (75), the width of which determines the deflection of the leaf springs (82) between two end positions.

8. Assembly rack according to one or more of the preceding claims, characterised thereby, that a front plate (70a) consists of a forward first plate (92) and an inward second plate (93), which displays bent-over rims (93a, 93b), of which one rim (93a) is arranged in alignment with the rim of the forward plate (92) and the second rim (93b) is set back by the thickness of the strip (75) in the direction of the centre of the plate relative to the rim of the forward plate (92), which strip (75) is fastened at the bent-over rim whilst clamping in a leaf spring (82), which makes an arc around that rim of the strip (75), which is remote from the front side of the front plate (70), and projects by an end, which is bent over towards the centre of the plate, into a groove (76) of the strip (75), which limits the deflection of the spring perpendicularly to the bent-over end of the inward plate.

9. Assembly rack according to one or more of the preceding claims, characterised thereby, that a hood (89), which is U-shaped in cross-section and longitudinal section and at the bent-over side rims (90, 91) of which respective strips (75) are fastened, is fastened at the rear side of the assembly rack (1), which strips (75) connect the side rims (90, 91) with leaf springs (82), which lie against the side walls (2, 3) of the assembly rack (1), extend in arcs around those ends of the strip (75), which face the assembly rack (1), and which have ends which are bent over in the direction of the centre of the hood and project into grooves (76) of the strip (75), which limit the deflection of the leaf springs transversely to the side walls (2, 3).

10. Assembly rack, in particular according to one or more of the preceding claims, characterised thereby, that the upper and lower profile rail (5, 3a) each displays a respective groove (94), which is open to the front side of the assembly rack (1) and which displays a first portion (95), which is adjacent to the base of the groove and has a wider cross-section for at least one threaded strip (98) or for sliding nuts, and a second portion (99), which is of wider cross-section and arranged between the first portion (95) and the opening (100) of the groove (94), and that a leaf spring (102) is arranged under spring bias in the second portion (99) and displays a bearing place (110) at a wall portion (101) of the portion (99) as well as a portion (113), which is displaceable under spring bias in the direction of the depth of the groove and outside the groove (94) passes over into a bent-over strip (115), which projects in the direction opposite to the opening (100) of the groove (94).

11. Assembly rack according to one or more of the preceding claims, characterised thereby, that the cut-out portions extend over the bent-over ends of the leaf spring (102) at the spacing of threaded bores in a threaded strip (98) arranged in the first portion (95).

12. Assembly rack according to one or more of the preceding claims, characterised thereby, that the leaf spring (102) at one end contains a planar region (104), which passes over into an arc (108), which is matched to the widened portion (99) and continues into a straight portion (111) which, after a distance corresponding to the width of the groove (94), passes over curved into a further straight portion (113) followed by the bent-over end.

13. Assembly rack according to one or more of the preceding claims, characterised thereby, that the first and the second portion (95, 99) are formed to be symmetrical to a plane (96) extending through the centre of the groove (94).

14. Assembly rack according to one or more of the preceding claims, characterised thereby, that loops (105), which lie against a wall (106) of the groove (94), project from the planar region (104).

15. Assembly rack according to one or more of the preceding claims, characterised thereby, that the leaf spring (102) displays a further bearing place at a wall (106) of the groove (94).

16. Assembly rack according to one or more of the preceding claims, characterised thereby, that differently shaped lobes (123, 124), which alternate in the longitudinal direction of the leaf spring (122), go out from the end of the portion (111) at different levels relative to the portion (111), that the one kind of lobes (124) contains bent-over portions (126), which project beyond the groove (94), and that the other kind of lobes lie with their ends within the groove (94).

## Revendications

1. Rack pour sous-ensembles comportant deux parois latérales métalliques entre lesquelles s'étendent aux quatre angles des rails profilés en métal qui sont fixés sur les parois latérales et qui portent des supports de guidage, dans lesquels sont montés des sous-ensembles, un panneau de couverture métallique supérieur et/ou un panneau de couverture métallique inférieur étant relié de manière électriquement conductrice avec les rails profilés avant et arrière et avec les parois latérales et en particulier les panneaux avant métalliques ou métallisés des sous-ensembles ayant une forme en U et comportant une première branche avec un ressort à lames et une seconde branche qui est conçue à la manière d'une surface de contact pour la liaison conductrice avec le ressort à lames du premier côté du panneau frontal, voisin dans le rack, caractérisé en ce qu'un ressort à lames (31) s'étend en un arc (35) autour du petit côté (34), tourné à l'opposé du panneau frontal (14), de la première branche (20), à une certaine distance de ce petit côté (34) et sur lequel le côté, tourné à l'opposé du sous-ensemble, de la première branche (20) est inséré et en contact dans une rainure (23) et en ce que la partie du ressort à lames (31), tournée vers le sous-ensemble voisin présente un décrochement (36) qui s'engage dans une rainure (29) limitant le déplacement en direction du sous-ensemble voisin.

2. Rack pour sous-ensembles selon la revendication 1, caractérisé en ce que la rainure (23), prévue dans la première branche (20) sur le côté tourné à l'opposé du sous-ensemble voisin, contient une paroi latérale (27) élargissant la section transversale de la rainure (23) en direction du fond de celle-ci, en ce qu'il est pressé contre la paroi latérale (27) un décrochement (32) du ressort à lames (31) et en ce que des pattes (33), faisant saillie du ressort à lames (31), s'appuient contre l'autre paroi latérale.

3. Rack pour sous-ensembles selon les revendications 1 ou 2, caractérisé en ce que sur le côté intérieur de chaque paroi latérale (2, 3) il est fixé à l'extrémité avant, entre le rail profilé supérieur (8) et le rail profilé intérieur (5), une baguette (39) et en ce qu'entre la paroi latérale (2, 3) et la baguette (39) il est serré un ressort à lames (31), qui s'étend en un arc autour d'un petit côté de la baguette (39) et qui présente, sur son côté opposé à la paroi latérale (2, 3), un décrochement (36) qui s'engage dans une rainure (29) limitant le déplacement en direction du sous-ensemble voisin.

4. Rack pour sous-ensembles selon une ou plusieurs des revendications précédentes, caractérisé en ce que les rails profilés arrière présentent chacun une rainure (48) ouverte vers le haut ou vers le bas avec un ressort (46), qui est pressé contre le bord (53) coudé, entourant l'angle du rail profilé, d'un panneau de couverture (52) arrière.

5. Rack pour sous-ensembles en particulier selon une ou plusieurs des revendications précédentes, caractérisé en ce que le panneau frontal (70) possède des bords (71, 72) latéraux coudés et en ce qu'entre les parois latérales (2, 3) et les bords (71, 72) recouvrant un peu celles-ci de l'intérieur, il est prévu des ressorts à lames (82) qui présentent des arcs entre des extrémités serrées et des extrémités pouvant être déviées transversalement aux parois latérales (2, 3) à l'intérieur de butées, arcs avec lesquels les ressorts à lames sont déviés en V ou en U.

6. Rack pour sous-ensembles selon une ou plusieurs des revendications précédentes, caractérisé en ce qu'un ressort à lames (82) est serré sur chaque côté intérieur (2, 3) du rack.

7. Rack pour sous-ensembles selon une ou plusieurs des revendications précédentes, caractérisé en ce que des ressorts à lames (82) sont serrés à une extrémité entre une baguette (75) et une surface d'appui et sont guidés en V ou en U dans des arcs autour des petits côtés de baguettes (75) et en ce que les ressorts à lames (82) s'engagent avec les autres extrémités dans des rainures (76) des baguettes (75), dont la largeur détermine la déviation des ressorts à lames (82) entre deux positions de fin de course.

8. Rack pour sous-ensembles selon une ou plusieurs des revendications précédentes, caractérisé en ce qu'un panneau frontal (70a) est constitué d'un premier panneau (92) avant et d'un second panneau (93) intérieur qui présente des bords (93a, 93b) coudés, dont un bord (93a) est aligné avec le bord du panneau avant (92) et le second bord (93b) est en retrait contre le bord du panneau avant (92), en direction du milieu du panneau, sur une distance correspondant à l'épaisseur de la baguette (75), qui est fixée sur le bord coudé, par serrage d'un ressort à lames (82), qui fait un arc autour du bord de la baguette (75), tourné à l'opposé du côté avant du panneau frontal (70) et qui s'engage avec une extrémité coudée vers le milieu du panneau, dans une rainure (76) de la baguette (75), qui délimite la déviation du ressort, perpendiculairement à l'extrémité coudée du panneau intérieur.

9. Rack pour sous-ensembles selon une ou plusieurs des revendications précédentes, caractérisé en ce que sur le côté arrière du rack (1) est fixé un capot (89) en forme de U dans sa section transversale et longitudinale, sur les bords latéraux (90, 91) courbés duquel sont fixées des baguettes (75), qui relient avec les bords latéraux (90, 91), des ressorts à lames (82) lesquels s'appliquent contre les parois latérales (2, 3) du rack (1) et s'étendent en arcs autour des extrémités, tournées vers le rack (1), des baguettes (75), et possèdent des extrémités coudées en direction du milieu du capot, lesquelles s'engagent dans des rainures (76) des baguettes (75), qui délimitent la déviation des ressorts à lames, transversalement aux parois latérales (2, 3).

10. Rack pour sous-ensembles en particulier selon une ou plusieurs des revendications précédentes, caractérisé en ce que le rail profilé supérieur (5) et le rail profilé inférieur (3a) présentent chacun une rainure (94) ouverte vers le côté avant du rack (1), laquelle présente une première partie (95) voisine du fond de la rainure avec une section transversale plus large pour au moins une tige filetée (98) ou pour des écrous glissants et une seconde partie (99), placée entre la première partie (95) et l'ouverture (100) de la rainure (94), avec une section transversale élargie et en ce que dans la seconde partie (99) il est prévu un ressort à lames (102) précontraint qui présente un point d'appui (110) contre une partie de paroi (101) de la partie (99) et une partie (113), laquelle peut coulisser sous précontrainte du ressort en direction de la profondeur de la rainure et se prolonge, à l'extérieur de la rainure (94), par une bande (115) coudée, qui s'étend dans la direction opposée à l'ouverture (100) de la rainure (94).

11. Rack pour sous-ensembles selon une ou plusieurs des revendications précédentes, caractérisé en ce que les découpes pratiquées à distance de taraudages dans une tige filetée (98), placée dans une première partie (95), s'étendent sur les extrémités coudées du ressort à lames (102).

12. Rack pour sous-ensembles selon une ou plusieurs des revendications précédentes, caractérisé en ce que le ressort à lames (102) contient à une extrémité, une zone (104) plane qui se prolonge, dans un arc (108) adapté à la partie (99) élargie, lequel se prolonge par une partie (111) rectiligne, qui, après une distance correspondant à la largeur de la rainure (94), se prolonge après courbure, en une autre partie (113) rectiligne à laquelle fait suite l'extrémité coudée.

13. Rack pour sous-ensembles selon une ou plusieurs des revendications précédentes, caractérisé en ce que la première partie (95) et la seconde partie (99) sont symétriques par rapport à un plan (96) passant par le milieu de la rainure (94).

14. Rack pour sous-ensembles selon une ou plusieurs des revendications précédentes, caractérisé en ce que de la zone (104) plane font saillie des boutons (105) qui s'appliquent contre une paroi (106) de la rainure (94).

15. Rack pour sous-ensembles selon une ou plusieurs des revendications précédentes, caractérisé en ce que le ressort à lames (102) présente un autre point d'appui contre une paroi (106) de la rainure (94).

16. Rack pour sous-ensembles selon une ou plusieurs des revendications précédentes, caractérisé en ce que de l'extrémité de la partie (111) partent à des niveaux différents vers la partie (111), des pattes (123, 124) de forme différente, qui alternent dans la direction longitudinale du ressort à lames (122), en ce qu'un type de patte (124) contient des parties (126) coudées qui dépassent de la rainure (94) et en ce que l'autre type de patte (123) se situe avec ses extrémités à l'intérieur de la rainure (94).
